(19) Europäisches Patentamt
European Patent Office
Office européen des brevets

(11) **EP 1 433 829 A1**

(12) **EUROPEAN PATENT APPLICATION**

(43) Date of publication:
**30.06.2004 Bulletin 2004/27**

(51) Int Cl.⁷: **C09J 7/02**, C08L 23/26, C08L 75/04, C08K 3/00, C08K 3/22, H01L 23/36, H01L 23/373

(21) Application number: **02028904.7**

(22) Date of filing: **23.12.2002**

(84) Designated Contracting States:
**AT BE BG CH CY CZ DE DK EE ES FI FR GB GR IE IT LI LU MC NL PT SE SI SK TR**
Designated Extension States:
**AL LT LV MK RO**

(71) Applicant: **3M Innovative Properties Company St. Paul, Minnesota 55133-3427 (US)**

(72) Inventors:
• **Boelz, Uwe**
  **41452 Dormagen (DE)**

• **Weber, Peter**
  **47447 Moers (DE)**
• **Reimann, Stefan**
  **51107 Köln (DE)**

(74) Representative: **Wilhelm, Stefan M. et al Office of Intellectual Property Counsel, c/o 3M Deutschland GmbH, Carl-Schurz-Strasse 1 41453 Neuss (DE)**

(54) **Thermally-formable and cross-linkable precursor of a thermally conductive material**

(57) The invention relates to a thermally-formable and cross-linkable precursor of a thermally-conductive material comprising a) one or more crosslinkable polymers where the melt flow index of the polymer or mixture of polymers (measured at 190 °C according to ASTM D-1238), respectively, is 10-100 g/10 min and b) one or more thermally-conductive fillers in an amount of at least 60 wt. % of the total weight of the precursor.

**Figure 1**

EP 1 433 829 A1

**Description**

<u>Field of the invention</u>

The invention relates to a thermally-formable and cross-linkable precursor of a thermally-conductive material and to the thermally-conductive material obtainable by cross-linking the precursor. The invention furthermore relates to a thermally-conductive adhesive tape comprising a backing and one or more adhesive layers wherein said backing comprises the thermally conductive material.

<u>Background</u>

Thermally-conductive materials are known and are used, for example, for providing a thermal bridge between printed circuit boards (PCBs) and heat sinks. Printed circuit boards generate heat under use conditions to the extent that this heat must be diffused to allow continuous use of the PCB. Heat sinks in the form of metal blocks are commonly attached to PCBs to allow excess heat to be conducted away from the PCB and radiated into the atmosphere. Known thermally-conductive materials are based on, for example, gel masses, pads or greases that must be mechanically clamped between the PCB and heat sink.

More recently, thermally-conductive adhesive tapes comprising an adhesive material have been introduced. These thermally-conductive tapes have the advantage that they form an adhesive bond with the two substrates to be connected and no mechanical clamping is required. Though heat-activatable adhesives can be used, pressure-sensitive adhesives (PSAs) have the additional advantage that an adhesive bond is formed by simply pressing the assembly, comprising the substrates sandwiching the adhesive material, together at room temperature without requiring that the adhesive be activated with heat. Two approaches have been used for providing thermally-conductive adhesive tapes having pressure-sensitive adhesive characteristics.

One approach for providing thermally-conductive adhesive tapes employs a thermally-conductive adhesive material. This approach has the advantage that only a single layer of such adhesive material is required to provide an adhesive tape. One disadvantage, however, is that thermally-conductive fillers must be added directly to the adhesive material and this may tend to reduce the quality of the adhesive bond. Adhesive tapes comprising no supportive and strengthening backing typically also need to have a relatively high thickness and thicker adhesive tapes inherently provide a relatively high thermal resistance due to the large distance over which the energy must be transmitted. Relatively thick, soft adhesive tapes are also difficult to cut into small discrete pieces by common converting techniques such as die-cutting.

A second approach for providing thermally-conductive adhesive tapes employs a polymeric film backing bearing separate layers of PSA on both surfaces. United States Patent US 6,165,612 (Bergquist) discloses a thermally conductive, electrically insulative mounting pad to be positioned between a base surface of a heat-generating solid state electronic device and a mounting surface of a heat-sink; said mounting pad comprising a film consisting of polyphenylsulfone matrix impregnated with a thermally-conductive particulate filler in an amount ranging from 10 - 50 % by weight of polyphenylsulfone. The mounting pads optionally comprise layers of adhesive on both sides.

United States Patent 5,213,868 (Chomerics) discloses a thermally-conductive support material bearing thermally conductive pressure-sensitive adhesive on both surfaces, where at least one exposed adhesive surface has embossments, grooves or channels to suppress air entrapment.

Japanese patent application JP 2000319454 discloses a flame-retardant adhesive tape comprising a backing of silane-crosslinked ethylene-based polymers. Thermal conductivity is not discussed in this reference.

Known commercially available adhesive tapes having a polymeric film backing include THERMATTACH[TM] T404 (available from Chomerics, Woburn, MA/USA) which comprises a polyimide film backing and BONDPLY[TM] 660 (available from The Bergquist Company, Edina, MN/USA) which comprises a polyethylenenapthalate (PEN)-based polymeric film backing.

This second approach for providing thermally-conductive adhesive tapes has also proven to be technically viable and commercially successful, but polymeric film backings that provide acceptable thermal and electrical properties and are suitable for use in such tapes can be difficult to manufacture and are often high in cost.

It is an object of the invention to provide new thermally-conductive adhesive tapes which have an improved combination of thermal, electrical and adhesive properties and are obtainable by simple and cost-effective manufacturing methods. Another object of the invention is to provide new thermally-conductive materials which have an advantageous thermal stability, a high breakdown voltage and an advantageous thermal conductivity. It is another object of the invention to provide new thermally-conductive materials suitable for use as a backing or thermally-conductive tapes. Other objects of the invention can readily be taken from the following detailed specification.

Brief summary of the invention

The invention describes a thermally-formable and crosslinkable precursor of a thermally-conductive material comprising a) one or more crosslinkable polymers where the melt flow index of the polymer or polymers (measured at 190 °C according to ASTM D-1238), respectively, is 10 - 100 g /10 min and b) one or more thermally-conductive fillers in an amount of at least 60 wt. % of the total weight of the precursor.

The invention also refers to a method of manufacturing the precursor comprising the steps of: a) providing one or more crosslinkable polymers where the melt flow index of the polymer or mixture of polymers, respectively, is 10 -100 g/10 min (as measured at 190 °C according to ASTMD-1238) and b) compounding the polymer or mixture of polymers with one or more thermally-conductive fillers in an amount of at least 60 wt. % based on the total weight of the precursor.

The invention also describes a method of providing the precursor comprising the steps of: a) providing one or more polymers where the polymer or mixture of polymers, respectively, has a melt flow index of 10 - 100 g/10 min (as measured at 190 °C according to ASTMD-1238) and wherein at least one of the polymers has an ethylene unit content of at least 30 % by weight, b) reacting the polymer with a vinyl silane of the formula RR'SiY$_2$ (I), wherein R is a monovalently olefinically unsaturated radical, R' is a monovalent radical free of aliphatic unsaturation and Y is a hydolyzable organic radical, and a free-radical initiator in a heated mixing device to produce a moisture-curable polymer and c) compounding the moisture-curable polymer with one or more thermally-conductive fillers in an amount of at least 60 wt. % of the total weight of the precursor in a heated mixing device. The invention also refers to a method of manufacturing a shaped thermally-conductive material comprising the steps of: a) providing the precursor of present invention, b) thermally forming the precursor to a desired shape and c) crosslinking the precursor.

The invention also describes a thermally-conductive material obtainable by the method of the invention.

The invention also describes an adhesive tape comprising at least a film backing bearing an adhesive layer on at least one of the major surfaces of the film backing, wherein the film backing is obtainable by extruding the precursor into the shape of a film and crosslinking the film.

The invention also refers to the use of the adhesive tape of the present invention for providing thermal conductivity between two substrates.

Furthermore, the invention describes an assembly comprising the adhesive tape in a bonding relationship between two substrates.

Brief description of the figure

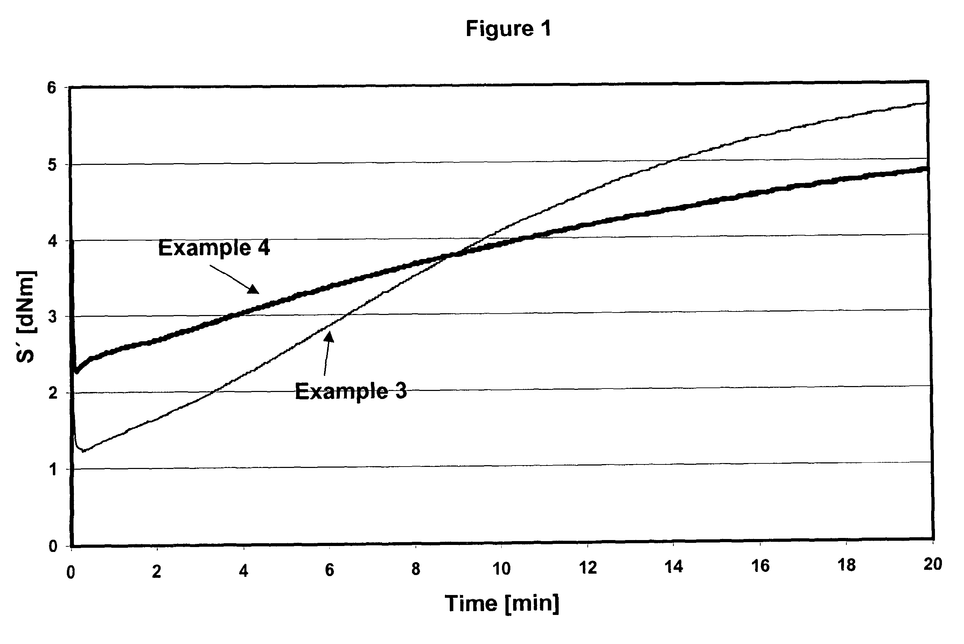

Figure 1 shows the changes in the elastic torque, S', of the precursor of Examples 3 and 4 of the present invention while exposed to a temperature of 200 °C for a period of 20 minutes.

Detailed description of the invention

The invention provides a thermally-formable and crosslinkable precursor of a thermally-conductive material comprising a) one or more crosslinkable polymers where the melt flow index of the polymer or mixture of polymers, respectively (measured at 190 °C according to ASTM D-1238 ) is 10 - 100 g /10 min and b) one or more thermally-conductive fillers in an amount of at least 60 wt. % of the total weight of the precursor. Thermal conductivity can be measured using the method specified below. Materials having a thermal conductivity of at least 0.30 W/m°C, preferably at least 0.35 W/m°C and more preferably 0.40 W/m°C are termed above and below as thermally-conductive. Above and below, the term "thermally-formable" means capable of being altered in shape under the influence of heat.

The precursor comprises one or more polymers where the polymer or mixture of polymers, respectively, has a melt flow index of 10-100 g/10 min, preferably 15-95 g/10 min and especially preferably 15-90 g/10 min (as measured according to ASTM D-1238 at 190 °C) and is capable of being crosslinked. Polymers which meet these requirements are preferably selected from the group comprising polyolefins, polyurethanes, silicones, polyvinyl chloride, polyvinyl ethers, polyvinyl acetate and polystyrenes. The group of polyolefins and polyurethanes is preferred, however, as these materials tend to provide thermal stability and flexibility required by adhesive tape applications.

The precursor preferably comprises 1-5, more preferably 1-3 and especially preferably 1-2 polymers where the polymer or mixture of polymers, respectively, has a melt flow index of 10-100 g/10 min, preferably 15-95 g/10 min and more preferably 20-90 g/10 min. If the polymer comprises polymers having a melt flow index of between 10-100 g/10 min and polymers having a melt flow index outside of this range, the amounts of such polymers are preferably selected so that the melt flow index of the mixture is between 10-100 g/10 min.

The polymer of the precursor may also optionally comprise other non-crosslinkable polymers in an amount of up to 30 wt. %, and more preferably up to 15 wt. %, based on the total weight of the precursor.

Polyolefinic polymers include homopolymers and copolymers of ethylene, propylene and butene and also include copolymers of olefins with other vinyl-group containing monomers such as (meth)acrylates, alpha-olefins such as 1-hexene and 1-octene, vinyl acetate and vinyl aromatics such as styrene.

Polyurethane polymers useful in the present invention include both saturated and unsatruated polyurethane polymers, prepared by known methods from diosocynates and diols, respectively.

The precursor comprises one or more polymers, where the polymer or mixture of polymers, respectively, has a melt flow index (MFI) of 10-100 g/10 min as measured at 190 °C by ASTM D-1238. Polymers or mixtures of polymers, respectively, that have a melt flow index of less than 10 g/10 min tend to be difficult to extrude because of their high molecular weight. Polymers with a melt flow index of less than 10 g/10 min have a relatively high melt viscosity and the viscosity of the precursor tends to increase as high amounts of fillers are added. Thus polymers with a melt flow index (MFI) of less than 10 g/10 min are not suitable for use in the present invention.

Polymers with a melt flow index (MFI) of greater than 100 g/10 min are also unsuitable for use in the present invention as they have a relatively low molecular weight. These polymers would need to have their effective molecular weight increased greatly after thermal forming into a film, for example, to provide the thermally stability and high-temperature performance required of the thermally-conductive adhesive tape end-product. Crosslinking capability can be introduced into the precursor so as to provide a route to effectively increase the molecular weight after extrusion and to improve thermal stability of polymers. Crosslinking is more conveniently and frequently used, however, to increase the molecular weight of polymers which already have a substantial molecular weight. Thus polymers with a melt flow index of greater than 100 g/10 min are also unsuitable for use in the precursor of the present invention.

The polymer or polymers, respectively, selected for use in the precursor must also be capable of being crosslinked. Crosslinking of the polymer may be effected by several methods, including radiation crosslinking (ultraviolet and e-beam), thermal cross-linking and crosslinking via moisture-curing. Radiation-induced crosslinking has the disadvantage that it often results in gradient curing effects through the thickness of the thermally-formed and crosslinked material. Thermal crosslinking may be employed, but has the disadvantage that thermal curing may already take place during the thermal forming by extrusion, for example, as relatively high temperatures required for extrusion are often similar to temperatures required for thermal crosslinking. Crosslinking of the precursor via moisture-curing is therefore preferred.

Polymers which are capable of undergoing crosslinking via moisture-curing include, for example, polyurethanes and polymers bearing reactive silane groups.

Polyurethanes undergo moisture curing by reaction of isocyanate groups with ambient moisture, while polymers bearing reactive silane groups undergo moisture curing by silanol condensation reactions or hydrosilation in the presence of platinum-based catalysts. The reactive silane groups can be introduced into suitable polymers via a grafting reaction.

Polymers for use in the thermally-formable and crosslinkable precursor of the present invention which are suitable for silane grafting include polyolefin polymers. The polyolefin polymer selected for silane grafting preferably comprises at least 30 %, more preferably at least 35 % and especially preferably at least 40 % by weight of polyethylene units. The presence of at least 30 % by weight of polyethylene units provides an effective number of grafting sites on the polymer backbone, which in turn provides an effective amount of crosslinking after thermal forming of the precursor into a specific shape, such as a film, for example.

Polyethylene polymers suitable for silane grafting include polyethylene homopolymers of a wide variety of densities, as well as polyethylene copolymers with (meth)acrylate monomers, vinyl acetate and alpha-olefins such as propylene, butene, pentene, 1- hexene and 1- octene.

A first group of specifically preferred polyolefins suitable for silane grafting comprises ultra low density polyethylenes (also known as very low density polyethylenes) having a density of less than 0.90 g/cm$^3$. Such materials are commercially available, for example, as

ENGAGE$^{TM}$ 8400 (ethylene-co-octene having a density of 0.870 g/cm$^3$ according to ASTM D-792, a melt flow index (MFI) according to ASTM D-1238 of 30 g/10 min and a melting peak as determined by DSC at a rate of 10°C / min of 60 °C);
ENGAGE$^{TM}$ 8411 (ethylene-co-octene having a density of 0.880 g/cm$^3$ according to ASTM D-792, a melt flow index (MFI) according to ASTM D-1238 of 18 g/10 min and a melting peak as determined by DSC at a rate of 10 °C / min of 72 °C);
ENGAGE$^{TM}$ 8401 (ethylene-co-octene having a density of 0.885 g/cm$^3$ according to ASTM D-792, a melt flow index (MFI) according to ASTM D-1238 of 30 g/10 min and a melting peak as determined by DSC at a rate of 10°C / min of 78 °C); and
ENGAGE$^{TM}$ 8130(ethylene-co-octene having a density of 0.864 g/cm$^3$ according to ASTM D-792, a melt flow index (MFI) according to ASTM D-1238 of 13 g/10 min and a melting peak as determined by DSC at a rate of 10°C / min of 50 °C).

ENGAGE™ polyolefins are available from Dow DuPont Elastomers (Geneva, Switzerland). Especially preferred materials from this group are ENGAGE$^{TM}$ 8400 and ENGAGE$^{TM}$ 8407.

The ultra low density polyethylene polymer is preferably selected so that the melting peak of the polymer as measured by DSC at a rate of 10°C / min is less than 100°C, more preferably less than 90°C and especially preferably between 60 °C and 80 °C.

A second group of preferred polyethylenes suitable for silane grafting and specifically preferred for use in the precursor of the present invention comprises copolymers of ethylene and (meth)acrylate monomers , available, for example, as

LOTRYL$^{TM}$ 35 BA 40, a copolymer of ethylene and butyl acrylate (co-E-BA) in a ratio of 65 parts ethylene to 35 parts butyl acrylate having a density of 0.930 g/cm$^3$ and a melt flow index (MFI) according to ASTM D-1238 (190 °C) of 40 g/10 min);

LOTRYL$^{TM}$ 17 BA 07, a copolymer of ethylene and butyl acrylate (co-E-BA) in a ratio of 83 parts ethylene to 17 parts butyl acrylate having a density of 0.930 g/cm$^3$ and a melt flow index (MFI) according to ASTM D-1238 (190°C) of 6.5 - 8 g/10 min);

LOTRYL$^{TM}$ 28 BA 175, a copolymer of ethylene and butyl acrylate (co-E-BA) in a ratio of 72 parts ethylene to 28 parts butyl acrylate having a density of 0.930 g/cm$^3$ and a melt flow index (MFI) according to ASTM D-1238 (190 °C) of 150 - 200 g/10 min); and

LOTRYL™ 28 MA 07, a copolymer of ethylene and methyl acrylate (co-E-MA) in a ratio of 72 parts ethylene to 28 parts methyl acrylate having a density of 0.930 g/cm$^3$ and a melt flow index (MFI) according to ASTM D-1238 (190°C) of 6 - 8 g/10 min).

LOTRYL$^{TM}$ copolymers are available from ATOFINA (Duesseldorf, Germany).

Other suitable ethylene-co-(meth)acrylate polymers suitable for silane grarting and suitable for use in the precursor of the present invention are those which also comprise polymerized units of maleic anhydride. These materials are commercially available from Elf Atochem (Puteaux, France) as

LOTADER$^{TM}$ 6200, a terpolymer of ethylene, acrylic ester and maleic anhydride, having a comonomer content of 9 %, a melt flow index of 40 g/10 min and a melting point by DSC of 102 °C;

LOTADER$^{TM}$ 8200, a terpolymer of ethylene, acrylic ester and maleic anhydride, having a comonomer content of 9 %, a melt flow index of 200 g/10 min and a melting point by DSC of 100 °C;

LOTADER™ 5500, a terpolymer of ethylene, and acrylic ester and maleic anhydride having a comonomer content of 22 %, a melt flow index of 20 g/10 min and a melting point by DSC of 80 °C; and

LOTADER™ 7500, a terpolymer of ethylene, and acrylic ester and maleic anhydride having a comonomer content of 20 %, a melt flow index of 70 g/10 min and a melting point by DSC of 76 °C.

Preferably a single polymer having a melt flow index of 10 - 100 g/10 min, such as LOTRYL$^{TM}$ 35 BA 40, is selected from the group of ethylene-co-(meth)acrylate polymers.

The melting point of polymers selected from the group of ethylene-co-(meth)acrylate polymers is preferably less than 100 °C and more preferably less than 80°C.

The crosslinkable polymers or polymers for use in the precursor of the thermally-conductive material of the present invention are preferably selected to give flexibility to the thermally-formed and crosslinked material. Flexibility is important to allow conformability of the adhesive tape to rough surfaces and to allow it to fill uneven or irregular bonding spaces or gaps. Polymers having a glass transition temperature, Tg, in the range of between -60 °C and -10 °C in the uncrosslinked state often exhibit such desirable characteristics.

The polymer is also preferably selected to impart strength to the polymeric film backing so that the resulting thermally-conductive adhesive tape can be handled, converted and applied to the substrates without stretching or breaking.

The polymer is also selected to be thermally stable. Preferred polymers for use in the precursor are those that are thermally stable (no weight loss) as measured by thermogravimetric analysis (TGA) at 350 °C in air, according to DIN IEC 60811-4-1.

Reactive silane groups capable of undergoing moisture-crosslinking may be incorporated into polymers in specific locations, such as on one or both ends, for example. Reactive silane groups may also be incorporated directly into copolymer backbones in a random fashion by copolymerization of unsaturated silane monomers. Reactive silane-functionality may also be also introduced into polymers by free-radically induced grafting techniques.

Such grafting techniques for introducing reactive silane functionality onto polymers which are preferred in the present invention are described in United States Patent US 3,646,155, United States Patent US 4,291,136, British Patent Specification GB 1 357 549, British Patent Specification GB 1 406 680, British Patent Specification GB 1 450 934 and German Patent DE 44 02 943, for example.

Silanes which can be employed in the grafting reaction have the general formula (I) R R'SiY$_2$. R represents a monovalent olefinically unsaturated radical attached to silicon through a silicon to carbon bond. Examples of such radicals are allyl, vinyl, butenyl and cyclohexenyl, where vinyl is preferred. Y represents a hydrolyzable organic radical, such as, for example, an alkoxy radical such as methoxy, ethoxy and butoxy radicals. Y may also be an acyloxy radical such as formyloxy, acetoxy or propionoxy, for example. Y may also be an oximo radical or a substituted amino radical. The Y substituents in any given silane molecule may be the same or different. R' represents a monovalent hydrocarbon radical free of aliphatic unsaturation, such as, for example, methyl, ethyl, propyl, tetradecyl, octadecyl, phenyl, benzyl or tolyl. R' may also be a Y radical. Preferably the silane will have the formula RSiY$_3$, where R is vinyl, the most preferred silanes being vinyl triethoxysilane, vinyl trimethoxy silane and combinations thereof. The silane compounds described are meant to illustrate the invention without limiting it.

The amount of one or more silane compounds employed in the grafting reaction will depend on the reaction conditions and the type of polymer employed. The present inventors have found that to advantageously graft and crosslink polymers having a melt flow index of 10-100 g/10 min, the amount of one or more silane compounds employed in the grafting reaction is preferably selected to be at least 2 parts per 100 parts polymer, more preferably at least 3 parts per 100 parts polymer and most preferably 3 - 5 parts silane per 100 parts polymer. If less than 2 parts is employed, then insufficient number of silane molecules are introduced onto the polymer backbone, an insufficient amount of crosslinking takes place and the thermal stability of the resulting thermally-conductive material is too low.

Free-radical initiators suitable for promoting the grafting reaction are those capable of generating free-radical sites on the base polymer to be grafted and which have a half-life at the reaction temperature of preferably less than about 6 minutes, and more preferably less than 1 minute. Preferred free-radical initiators include organic peroxides and peresters such as, for example, benzoyl peroxide; dichlorobenzoyl peroxide; dicumyl peroxide; di-t-butyl peroxide; 1,1-di-t-butylperoxy-3,3,5-trimethylcyclohexane; 2,5-dimethyl-2,5-di(peroxybenzoate)hexylene-3; 1,3-bis(t-butylperoxyisopropyl) benzene; lauroyl peroxide; t-butyl peracetate; 2,5-dimethyl-2,5 (t-buytl peroxy)hexylene-3; t-butyl perbenzoate, and azo compounds, for example, azobisisobutyronitrile and dimethyl azodi-isobutyrate. The selection of a particular free-radical initiator depends on the temperature at which the silane grafting reaction is to be performed. Dicumylperoxide is most preferred as a free-radical initiator.

The free-radical initiator or initiators can preferably be employed in the amount of 0.10 - 0.30 parts per 100 parts polymer, more preferably at 0.15 - 0.25 parts per 100 parts polymer and most preferably at about 0.175 parts per 100 parts polymer. The present inventors have found that polymers or mixtures of polymers having a melt flow index (MFI) of 10-100 g/10 min can be grafted and crosslinked advantageously by employing the free-radical initiator in an amount of at least 0.1 parts per 100 parts polymer. If less than 0.1 parts is employed, then insufficient grafting takes place, resulting in thermally-conductive materials which have insufficient crosslinking. The silane grafting reaction is preferably performed at a temperature of between 120 °C and 220 °C, more preferably between 140 °C and 200 °C and most preferably between 160 °C and 180 °C.

Moisture-curing of silane-grafted polymers is known to be promoted and accelerated in the presence of silanol condensation catalysts. Though catalysts accelerate the moisture-curing, it is not required that they be employed in the precursor of the present invention. Known silanol condensation catalysts include metal carboxylates such as dibutyltin dilaurate, stannous ethyl hexanoate, stannous acetate, stannous octoate, and zinc octoate, for example. Organic metal compounds such as titanium esters and chelates are also effective catalysts as are organic bases such as hexyl amine. Acids such as mineral acids and fatty acids are also known as silanol condensation catalysts. When a catalyst is employed, organic tin compounds such as dibutyltin dilaurate, tin (II) ethyl hexanoate, dibutyltin diacetate and dibutyltin dioctoate are preferred.

The thermally-formable and cross-linkable precursor of the present invention comprises, in addition to the crosslinkable polymer, one or more thermally-conductive fillers. Any organic, inorganic or ceramic filler that effectively enhances thermal conductivity of a polymeric film may be employed as a filler in the precursor of the present invention.

Thermally-conductive fillers are defined above and below as those having a thermal conductivity, λ, at 20 °C, of at least 5.0 W/mK. Preferred thermally-conductive fillers are those which are electrically-insulating as well as thermally conductive.

The group of preferred thermally-conductive fillers includes but is not limited to alumina, aluminum oxide Al$_2$O$_3$, aluminum trihydroxide, magnesium hydroxide, beryllium oxide, magnesium oxide, zinc oxide, boron nitride, aluminum nitride and silicon carbide.

Most preferred thermally-conductive fillers are aluminum trihydroxide and magnesium hydroxide. An especially preferred thermally-conductive filler is magnesium hydroxide. More preferred is magnesium hydroxide that has been pretreated with a vinyl silane. Such silane-treated magnesium hydroxide is commercially available, for example, as MAGNIFIN H5A and MAGNIFIN H5MV from Alusuisse Martinswerk GmbH (Bergheim, Germany).

Suitable thermally-conductive filler or fillers for use in the precursor of the present invention are also preferred in particulate form. "Particulate filler", as defined above and below, is a finely divided solid filler having an average particle size of less than about 75 μm. Preferred size of particulate fillers for use in the precursor of the present invention are those with an average particle size of less that 20 μm. Most preferably is an average particle size of between 2 μm and 5 μm.

The thermally-conductive filler or fillers are present in the precursor of the present invention in an amount of at least 60 % by weight of the total weight of the precursor. At levels of below 60 wt. %, the thermally formed and crosslinked material shows insufficient thermal conductivity. The thermally-formable precursor is preferably filled with the maximum tolerable amount of filler to promote maximum thermal conductivity of the thermally-formed and thermally-conductive crosslinked material. The maximum amount of filler has been attained when the melt viscosity of the precursor becomes such that it cannot be thermally formed or extruded, for example, or when the polymer of the precursor is no longer capable of holding the filler. The filler is preferably present in the precursor of the present invention in the amount of at least 62.5 wt. % and more preferably 65 wt. % based on the total weight of the precursor.

The thermally-conductive filler or fillers of the precursor of the present invention can be chemically treated, for example, by treatment with silanes or stearic acid, to promote interaction with the polymer and to allow maximum filler loading in the precursor. Use of fillers in the amount of less that 60 % by weight tends to produce insufficient thermal conductivity. Use of filler in very high amounts, such as amounts of over 75 % by weight, for example, tends to raise the melt viscosity of the precursor and render it extremely difficult to extrude. Very high loading of filler also tends to produce thermally-conductive materials that have poor cohesive strength.

The precursor of the present invention may also comprise additional fillers and additives to the extent that the thermal conductivity and other physical properties of the thermally-formed and crosslinked material are not overly compromised. Low amounts of a solvents or inert diluents may be employed during compounding and extrusion to lower the viscosity of the precursor and improve mixing of the polymer and the filler, for example. Certain reactive diluents such as low molecular weight polymers comprising epoxide or acid groups may also be employed. Conventional wetting agents, anti-foaming agents, pigments, flame-retardants and antioxidants may be added to the precursor depending upon the requirements of the particular application envisioned. Preferably, the sum of the amounts of additional fillers and additives is an amount of less than 20 wt. % based on the total weight of the precursor. More preferably, the sum of the amounts of auxiliary fillers and additives is an amount of less than 10 wt. % based on the total weight of the precursor.

A particularly preferred additive for the precursor of the present invention is a low molecular weight organic extender. A low molecular weight organic extender is defined above and below as a monomeric or polymeric organic substance having a weight average molecular weight, $M_w$, of less than about 20,000. The organic extender may be selected from the group of materials commonly known as extender oils such as mineral oil and plasticizers such as dioctyl phthalate (DOP). The low molecular weight organic extender is present in the amount of at least 5 wt. % based on the total weight of the precursor. Preferably the extender is present in the amount of between 10 wt. % and 20 wt. %.

The thermally-conductive filler or fillers are mixed with the crosslinkable polymer before the precursor is thermally-formed into its final shape. In general, compounding of the crosslinkable polymer with filler can most easily be accomplished by adding the filler or fillers to the polymer melt in a heated mixing device such as an internal mixer (a Branbury™ -type mixer, for example) or an extruder.

The thermally-formable precursor of the present invention is tack free at 23 °C and cannot be characterized as having pressure-sensitive adhesive (PSA) properties. The term "tack free" means qualitatively that the crosslinked precursor is not sticky to the touch. The term "tack free" means quantitatively that the crosslinked precursor has a 90° peel adhesion value from stainless steel of less than 0.5 N/ cm as measured according to AFERA (Association des Fabricants Europeens de Rubans Auto-Adhesivs) 4001.

The invention also provides a method of manufacturing the precursor of the present invention comprising the steps of a) providing one or more crosslinkable polymers where the polymer or mixture of polymers, respectively, has a melt flow index of 10 -100 g/10 min (as measured according to ASTM D-1238 at 190 °C) and b) compounding the polymer or polymers, respectively, with a thermally-conductive filler in an amount of at least 60 wt. % of the total weight of the precursor in a heated mixing device. The invention furthermore provides a preferred method of manufacturing the precursor that specifically relates to embodiments where silane-grafting and moisture curing of the precursor are employed. This method of manufacturing the precursor comprises the steps of a) providing one or more polymers where the polymer or mixture of polymers, respectively, has a melt flow index of 10 - 100 g/10 min (as measured according to ASTM D-1238 at 190 °C) b) reacting the polymer or polymers with a vinyl silane having the formula $RR'SiY_2$ (I), wherein R is a monovalently olefinically unsaturated radical, R' is a monovalent radical free of aliphatic unsaturation and Y is a hydolyzable organic radical, and a free-radical initiator in a heated mixing device to produce a moisture-curable polymer and c) compounding the moisture-curable polymer with one or more thermally-conductive fillers in an amount of at least 60 wt. % of the total weight of the precursor in a heated mixing device. The crosslinkable polymer preferably has an ethylene unit content of at least 30 % by weight with respect to the total weight of the crosslinkable polymer and the vinyl silane preferably has the formula $RR'SiY_2$. Preferred embodiments of R, R' and Y are described above.

The free-radical induced grafting reaction of the silane onto the polymer is preferably conducted at temperatures of 120 °C to 220 °C in a heated mixing device such as an internal mixer (a Branbury™-type mixer, for example) or an extruder. If the grafting reaction temperature is too low, the viscosity of the polymer is too high to achieve good mixing with the vinyl silane and the free-radical initiator and the initiator may fail to decompose thermally as required. If the grafting reaction temperature is too high then disadvantageous side reactions are promoted.

Residence times for the grafting mixture in the heated mixing device of less than 10 minutes are preferred, with a residence time of less than 5 minutes being most preferred.

In embodiments where silane grafting is employed to render the polymer crosslinkable, the thermally-conductive filler or fillers are preferably compounded with the polymer melt after the silane grafting reaction has occurred, but before the silane-grafted polymer is crosslinked. Preferably the thermally-conductive filler or fillers are added in a subsequent step after grafting, in the same extruder, so that a reduced number of extruding and/or mixing steps is required.

The silanol condensation catalyst, when employed, can be mixed into the polymer melt as the polymer is thermally-formed into its final shape by extrusion, for example, or may be applied in solution to the surface of an extruded polymeric film, for example. The rate of the moisture-curing or crosslinking reaction may be accelerated with heat. Temperatures of between 23 °C and 70 °C may be employed. Complete moisture curing a 100 - 300 μm thick film of the precursor of the present invention requires approximately one day at a temperature of 23 °C and ambient relative humidity. Curing may be effected in 10-15 minutes at temperatures of 70 °C, however.

The invention also provides a method of manufacturing a shaped thermally-conductive material, comprising the steps of providing the thermally-formable precursor of the present invention, thermally forming the precursor to a desired shape and then crosslinking the precursor.

The precursor can be shaped by any known method for forming polymeric materials. Thermal forming of the precursor can comprise injection molding, for example, to form a three-dimensional body. Thermal forming of the precursor may also be performed by extrusion, for example, to form a sheet, ribbon or thin film. Thermal forming of the precursor into a thick sheet may be conducted by calendaring techniques as well.

In general, thermal formability of the precursor is ensured by preferably selecting the polymers of the precursor from the group comprising known thermoplastic polymeric materials capable of flowing with reduced viscosity when heated. Thermoset polymeric materials, such as epoxies, for example, are less preferred for use in the precursor of the present invention because of their tendency to undergo irreversible chemical reaction under conditions commonly employed for processing the precursor prior to the crosslinking step.

The invention also describes a thermally-conductive material obtainable by crosslinking the precursor of the present invention. The thermally conductive material of the present invention is tack free at 23 °C and cannot be characterized as having pressure-sensitive adhesive (PSA) properties. The term "tack free" means qualitatively that the crosslinked precursor is not sticky to the touch. The term "tack free" means quantitatively that the crosslinked precursor has a peel adhesion value from stainless steel of less than 0.5 N/cm as measured according to AFERA (Association des Fabricants Europeens de Rubans Auto-Adhesivs) 4001.

The crosslinked thermally-conductive material of the present invention is preferably crosslinked to the extent that it exhibits an elastic torque, S', of 3 - 8 dNm, more preferably 4 - 7 dNm, as measured by ASTM D 6294-9 after crosslinking at 200 °C for 20 minutes. Materials having an elastic torque, S', of less than 3 dNm tend to have inferior thermal stability and poor high temperature performance under real use conditions. Materials having an elastic torque, S', of greater than 8 dNm tend to lack conformability and flexibility.

Figure 1 shows the crosslinking behavior of the precursor of Examples 3 and 4. Elastic torque, S', of the precursor is shown as a function of time for a period of 20 minutes while being held at a temperature of 200 °C.

The precursor of the present invention is preferably thermally-formed into the shape of a film. Film lends itself easily to the formation of interfaces between relatively flat substrates and can easily be provided with coating or other thin layers such as adhesives. The precursor is also preferably formed into a film as this facilitates application of crosslinking techniques. Radiation curing can be employed effectively on films and, in embodiments where moisture-curing is preferred, thin films allow adequate contact with ambient moisture to effect crosslinking via moisture curing within reasonable times and temperatures.

The thermally-conductive film suitable for use in the thermally-conductive adhesive tape of the present invention preferably has a thickness of 40 - 300 μm. Especially preferred is a film thickness of 100 - 200 μm. If the film is too thick, then the thermal impedance is too high. If the film is too thin, the breakdown voltage of the resulting tape tends to be too low, the backing is too thin to handle and it cannot contribute sufficiently to gap-filling properties required of the adhesive tape.

The thermally-conductive film suitable for use in the thermally-conductive adhesive tape of the present invention preferably is flexible, conformable and elastic. Such qualitative characteristics are reflected quantitatively in measurable film properties such as the E-modulus. Preferably the thermally-conductive film has an E-modulus of 6 -100 N/mm$^2$ and more preferably 20 - 50 N/mm$^2$.

The present invention also provides an adhesive tape comprising at least a film backing bearing an adhesive layer on at least one major surface of the film backing, wherein the film backing is obtainable by extruding the precursor of the present invention into a film and crosslinking the film. Preferred classes of adhesive materials are those known to have good thermal stability and resistance to aging, degradation and oxidation at high temperatures. Preferred adhesive polymer classes include acrylates, silicones and urethanes.

The adhesive layer applied to one or both major surfaces of the film backing may comprise a pressure-sensitive adhesive (PSA) which is inherently tacky at 23 °C or a heat-activatable adhesive that must be heated to develop tack.

Pressure-sensitive adhesive layers are preferred. Preferred pressure-sensitive adhesives (PSAs) are acrylate-based pressure-sensitive adhesives. Acrylate-based pressure-sensitive adhesives and methods of their preparation are described in Handbook of Pressure-Sensitive Adhesives (Ed. D. Satas, Third Edition, 1999). Acrylate-based PSAs comprise polymers or copolymers of acrylic and/or methacrylic esters that are inherently soft and tacky polymers having a low glass transition temperature ($T_g$). Preferred (meth)acrylate monomers for use in preparation of acrylic PSAs suitable for use in the present inventions comprise alkyl acrylate and methacrylate esters of non-tertiary alcohols comprising 4-17 carbon atoms where the homopolymer of the monomer has a $T_g$ of less than about 0 °C. Monomers suitable for use in acrylic PSAs which can be employed in the present invention include, for example, n-butyl acrylate, isobutyl acrylate, hexyl acrylate, 2-ethyl-hexylacrylate, isooctyl acrylate, caprolactone acrylate, isodecyl acrylate, tridecylacrylate, laurylmethacrylate, methoxy-polyethylenglycolmonomethacrylate, lauryl acrylate, tetrahydrofurfuryl acrylate, ethoxyethoxyethyl acrylate and ethoxylated nonylacrylate. Especially preferred are 2-ethyl-hexyl acrylate, isooctyl acrylate and butyl acrylate. The low $T_g$ (meth)acrylate monomer is commonly present in preferred (meth)acrylate-based PSAs in an amount of 50-100 % by weight.

Optionally, one or more ethylenically unsaturated co-monomers may be copolymerzed with the (meth)acrylate ester monomer described above in amounts of between 0 and 50 weight % to improve cohesive strength of the adhesive and/or provide other desirable characteristics. One class of useful comonomers includes those having a homopolymer glass transition temperature ($T_g$) greater than the glass transition temperature of the homopolymer of the (meth)acrylic esters listed in the preceding paragraph. Examples of suitable monomers falling within this class include acrylic acid, acrylamide, methacrylamide, substituted acrylamides such as N,N-dimethyl acrylamide and N,N-diethylacrylamide, itaconic acid, methacrylic acid, vinyl acetate, N-vinyl pyrrolidone, isobornyl acrylate, cyanatoethyl acrylate, N-vinylcaprolactam, maleic anhydride, hydroxyalkylacrylates, N,N-dimethylaminoethyl(meth)acrylate, beta-carboxyethylmethacrylate, vinylidene chloride, styrene, vinyl toluene and alkyl vinyl ethers.

The pressure-sensitive adhesive layer may also be crosslinked to improve its performance, in particular shear strength, at elevated temperatures. Crosslinking of the adhesive layer may be provided by radiation post-crosslinking, using e-beam or UV radiation, for example, or by thermal post-crosslinking using bisamide type crosslinkers, for example, or may be provided during the synthesis of the acrylic polymer by including multifunctional acrylates, such as hexanediol diacrylate, in the monomer mixture.

The adhesive layer may also comprise one or more thermally-conductive fillers. The filler type can be selected from the particulate fillers used in the above precursor. The thermally-conductive filler or fillers, when present, may be present in the adhesive layer in any amount which is effective in enhancing the thermal-conductivity of the adhesive tape of the present invention. The amount of filler or fillers in the adhesive layer should not adversely effect adhesive behavior so that the adhesive tape does not meet user requirements, however. If one or more fillers is present in the adhesive layer, an amount of less than 30 wt. % based on the total weight of the adhesive is preferred. Preferably, one or more fillers are employed in an amount of less than 15 wt. % based on the total weight of the adhesive. More preferably, the adhesive layer comprises less than 5 wt. % of one or more fillers and is especially preferably essentially free of thermally-conductive fillers.

The adhesive layer may also contain various additives commonly employed in adhesives, such as pigments, antioxidants, tackifiers, plasticizers and flame-retardants, for example. The amount of such additives is preferably not more than 20 wt. % based on the total weight of the adhesive.

The thickness of the adhesive layer is preferred to be 10 - 50 µm and more preferably 15 - 45 µm and especially preferably 15 - 25 µm.

Specifically preferred is an adhesive layer having a thickness of from 15 µm - 25 µm and where no thermally-conductive filler is present in the adhesive.

The adhesive layer may be applied to one or both major surfaces of the crosslinked and filled polymeric film backing and may be applied by any of the commonly known methods for generating thin adhesive films on substrates, including hot-melt extrusion coating of 100 % solids adhesives and application of adhesive from solvent, suspension or emulsion (followed by drying) using common techniques such as knife-coating, spraying, gravure-coating and screen-printing. An adhesive layer may also be prepared separately as a thin layer of adhesive supported on a release liner (a transfer tape) and then transferred by lamination to one or both major surfaces of the thermally-conductive crosslinked film backing according to the present invention.

The adhesive may also be applied to one or both surfaces of the crosslinked thermally-conductive film backing in a manner so that the adhesive only partially covers the major surface(s) to which it has been applied. This can be accomplished by screen-printing, for example, or by transfer of a segmented adhesive layer formed separately on a release liner. Adhesive layers applied in a manner so as to give only partial coverage of the polymeric film backing may be preferred in instances where it is critical to prevent air-entrapment at the interface between the adhesive and the substrate to which it is bonded, such as a PCBs or a heat sink, for example. Presence of air bubbles at the adhesive-substrate interface is known to reduce adhesive contact and reduce the ability of the adhesive to transmit thermal energy. The presence of small adhesive-free areas, in particular when using a pressure-sensitive adhesive layer, can facilitate removal of air bubbles from the bonding interface. In cases where partial coating of the thermally-conductive film backing with adhesive is employed, the area of one or both major surfaces of the thermally-conductive film backing is preferably covered with adhesive to the extent of at least 90 %, more preferably 95 %.

Other techniques may also be used to prevent entrapment of air bubbles at the bonding interface. One such preferred technique requires introduction of a three-dimensional character to the surface of the adhesive layer. This can be accomplished by contacting the adhesive surface with a microstructured or roughened release liner that transfers its three-dimensional character to the surface of the adhesive layer. Thermally-conductive adhesive tapes bearing at least one adhesive layer with embossments, channels or grooves are described in United States Patent No. 5, 213, 868 (Chomerics).

The adhesive tape of the present invention, including the thermally-conductive film backing having one or more adhesive layers, preferably has a thickness of less than 300 μm. More preferably, the thickness of the adhesive tape is between 100 μm and 275 μm. If the thickness of the adhesive tape is greater than 300 μm, its thermal impedance tends to be too high. If the thickness of the adhesive tape is less than 100 μm, then the dielectric strength of the adhesive tape and its conformability to substrates is insufficient.

Adhesive tapes having a dielectric strength of at least 55 kV/mm are preferred. Most preferred are adhesive tapes having a dielectric strength of at least 60 kV/mm. The dielectric strength of the adhesive tape is an important property for end use. Dielectric strength can be used to quantitatively reflect the ability of a material to resist the passage of electrical current and is measured according to DIN EN 60243-1. Adhesive tapes having a dielectric strength of less than 55 kV/mm exhibit insufficient electrical resistance and have a low breakdown voltage, i.e. that voltage at which an electric discharge is capable of passing completely through the adhesive tape.

The invention also provides a thermally conductive adhesive tape having an effective thermal conductivity of at least 0.4 W/m-K measured according to ASTM D 5470-95. Adhesive tapes which exhibit an effective thermal conductivity of less than 0.4 W/m-K cannot be relied upon to transmit thermal energy with the efficiency and speed required by the use conditions in the electronics industry.

The invention also provides a thermally-conductive adhesive tape having a thermal impedance of less than 6.0 °C-cm$^2$/ W as measured according to ASTM D 5470-95.

Preferred are adhesive tapes which have a dielectric strength of greater that 55 kV/mm, an effective thermal conductivity of at least 0.4 W/m-K and a thermal impedance of less than 6.0 °C-cm$^2$ / W.

The invention also refers to the use of the thermally-conductive crosslinked films for forming a thermally-conductive interface between two substrates, such as the surface of a heat-generating body and a heat-absorbing body, for example. The thermally-conductive crosslinked film which is obtainable by forming the precursor into the shape of a film with subsequent crosslinking, preferably comprises one or more adhesive layers to form an adhesive tape.

The invention also refers to a specific use, where the heat-generating body is a printed circuit board and the heat-absorbing body is a heat sink.

The invention also refers to an assembly comprising the thermally-conductive film of the present invention in a bonding relationship between two substrates.

Materials used in the Examples and Comparative Examples

*A. Crosslinkable Polymers*

ENGAGE 8400 - ethylene-co-octene having a density of 0.870 g/cm$^3$, available from Dow Dupont Elastomers (Geneva, Switzerland). Melt flow index (MFI) according to ASTM D-1238 of 30 g/10 min.

LOTRYL EA 35 BA 40 - ethylene and butyl acrylate (co-E-BA) in a ratio of 65 parts ethylene to 35 parts butyl acrylate having a density of 0.930 g/cm$^3$, available from ATOFINA (Duesseldorf, Germany). Melt flow index (MFI) according to ASTM D-1238 of 40 g/10 min.

LOTRYL 28 MA 07 - ethylene and methyl acrylate (co-E-BA) in a ratio of 72 parts ethylene to 28 parts methyl acrylate having a density of 0.95 g/cm$^3$, available from ATOFINA (Duesseldorf, Germany). Melt flow index (MFI) according to ASTM D-1238 of 7 g/10 min.

*B. Vinyl silane of the formula (I)*

Vinyl-trimethoxy silane, available as DYNASYLAN VTMO from Degussa AG (Hanau, Germany).

*C. Free-radical initiator*

Dicumylperoxide or 2,2-bis-phenylpropyl peroxide, available as Luperox DCSC (active oxygen level of 5.80-5.92 wt. %) from Atofina Deutschland GmbH (Gunzburg, Germany).

*D. Catalysts for moisture-curing (optional)*

Tin (II) ethyl hexanoate, available from Johnson Mathey GmbH (Karlsruhe, Germany)

*E. Thermally-conductive filler*

MAGNIFIN H5A, $Mg(OH)_2$ powder, vinyl silane-treated, available from Alusuisse Martinswerk GmbH (Bergheim, Germany). Specific Surface (BET) of 4.0 - 6.0 $m^2$ / g. Particle Size: $d_{50}$ 1.25 - 1.65 µm.

Test Methods:

*Breakdown voltage, kV*

The breakdown voltage for the adhesive tapes was measured according to DIN (Deutsche Industrie Norm) EN 60243-1. The results were recorded in kV.

*Dielectric strength, kV/mm*

The breakdown voltage of adhesive tapes was measured according to DIN EN 60243-1. The results were normalized to account for the thickness of the adhesive tape measured.

*Volume resistivity, ohm-cm*

The Volume Resistivity for adhesive tapes was measured according to DIN (Deutsche Industrie Norm) IEC 93. Results were recorded in ohm-cm.

*Effective thermal conductivity and thermal impedance*

Effective thermal conductivity and thermal impedance of the adhesive tapes were measured according to ASTM D 5470-95 (Thermal Transmission Properties of Thin Thermally Conductive Solid Electrical Insulation Materials) with the following modifications:

*a. Test apparatus*

The heat source employed in the test equipment was an insulated copper block (25.4 mm x 25.4mm) and 3 mm thick which was heated electrically with a constant power. The cooling unit was a copper block cooled by water supplied from a constant temperature bath such that the temperature is maintained uniformly within +/- 0.2° K. The heat source and cooling unit temperatures were measured independently with thin thermocouples placed exactly opposing one another on opposite sides of the test specimen. The thermocouple tip for the heat source was placed within the center of the copper plate. The thermocouple tip for the cooling unit was placed near the surface of the block.

*b. Test procedure*

For both effective thermal conductivity and thermal impedance, an adhesive tape specimen having a size of 25.4 mm x 25.4 mm was employed.

First, the thickness of the adhesive tape test specimen was measured at 23 °C. The test specimen was then centered between a heat source copper block at a higher temperature, $T_1$, and a cooling unit copper block at a lower temperature, $T_2$. A thermocouple was inserted into both copper blocks. A load of 1.75 kg was then applied on top of an insulator on top of the upper, heat source copper block, to hold the test assembly together and insure intimate contact between the adhesive tape test specimen and the copper blocks.

Cooling water was circulated to the cooling unit and power was applied to the heating element in the heat source. The temperature of both the heat source and the cooling unit was recorded at equilibrium. Equilibrium was attained when two successive sets of temperature readings taken at 15 min intervals had a difference of less than 0.2 K. Voltage, V (in volts), and current, I (in amps), at equilibrium were then recorded.

Specimens of the same adhesive tape having a variety of thicknesses were then evaluated in the same manner to give an equilibrium temperature for a range of thicknesses.

*c. Calculations*

*Effective thermal conductivity, k, in units of W/m K*

    1. Calculate the heat flow, Q, from the applied electrical power:
        Q = V x I, where V is voltage in volts and I is current in amps
    2. Calculate the effective thermal conductivity, k:
        k = (Q x s ) / (A x $\Delta$T), where
    Q = heat flow in Watts
    s = thickness of the adhesive tape in meters
    A = area of the adhesive tape in sq. m.
    $\Delta T = T_1 - T_2$

Results are reported in units of W/mK.

*Thermal impedance, Z, in units of $°C\text{-}cm^2$ / W*

Thermal impedance, Z, is defined as the temperature gradient per unit of heat flux, (Q / A), passing through the adhesive tape

$$Z = \Delta T \times (A / Q)$$

where
$\Delta T = T_1 - T_2$
A = area in sq. m.
Q = heat flow in Watts
R = thermal resistance in °C/W
and gives results in units of °C-cm$^2$ / W. R, thermal resistance, is defined as Z / A a is measured in units of °C/W.

*E-Modulus*

Determination of modulus of the adhesive tapes of the invention was conducted according to DIN (Deutsche Industrie Norm) 53455.

*Evaluating of rheological properties and crosslinking behavior of the precursor*

Samples of the uncrosslinked precursor having a weight of 6.8 - 7.0 grams for filled polymers and 3.9 - 4.2 grams for unfilled polymers were employed for the test in the shape of a disc. The sample discs were then placed in a rotorless oscillating shear rheometer commercially available as Rheometer Model MDR 2000 from Alpha Technologies located in Akron, Ohio/USA. The disc samples of the precursor were then heated in the rheometer chamber during which time moisture-curing of the precursor occured. Rheological properties of the precursor were measured and recorded as a function of time.

This test was performed according to ASTM D 6204 -99 Standard Test Method for Rubber - Measurement of Unvulcanized Rheological Properties Using a Rotorless Shear Rheometer. A strain of ± 2.8 % and a frequency of 0.5 Hz were employed.

The elastic torque, S', of the test materials comprising uncrosslinked precursor and moisture-curing cataylst after 20 minutes at 200 °C was reported in units of dNm.

Examples

*Example 1*

*a. Silane grafting of the polymer*

A free-radically induced grafting reaction was conducted by first introducing pellets of an ethylene-co-octene polymer having a density of 0.870 g/cm$^3$, melt flow index of 30 g / 10 min (measured at 190°C according to ASTM D-1238), available as ENGAGE 8400 from Dow Dupont Elastomers (Geneva, Switzerland) into a first extruder (single-screw) with a mixture of vinyl-trimethoxy silane (in the amount of 2.0 parts by weight silane per 100 parts polymer (or 0.66 wt. % based on the total weight of the filled precursor) and dicumylperoxide (in the amount of 0.085 parts by weight per 100 parts polymer or 0.03 wt. % based on the total weight of the filled precursor). The residence time of the polymer in the first extruder was about three minutes.

*b. Compounding grafted polymer with thermally-conductive filler and extruding*

The silane-grafted polymer thus formed was fed directly into a second extruder (twin-screw) and compounded with silane-treated $Mg(OH)_2$ powder available as MAGNIFIN TM H5A from Alusuisse Martinswerk (Bergheim, Germany) using a gravimetric feeder. Magnesium hydroxide was employed in the amount of two parts by weight for each part by weight of silane-grafted polymer, resulting in a precursor composition with about 66 wt. % filler based on total weight of the precursor. The grafted and filled precursor was then pelletized.

A catalyst comprising tin (II) ethyl hexanoate was combined with the pellets of precursor in a third extruder in the amount of 0.2 parts per 100 parts polymer (or 0.07 wt. % based on the total weight of the precursor) and the precursor was extruded into a film having a thickness of 200 μm. Specifically, a single screw extruder and a slot die were employed for this thermal forming operation. The residence time of the precursor in the extruder was limited to less than 5 minutes so as to avoid extensive crosslinking during the film extrusion process. Chemical composition of the film of Example 1 is summarized in Table 1.

*c. Moisture curing of the thermally-conductive film backing*

The thermally-conductive film thus formed was allowed to stand at 23 °C and 50 % relative humidity for 24 hours before testing to allow moisture curing of the silane-grafted ethylene-co-octene polymer. The thermally-conductive film thus prepared was then evaluated by the Modulus, Tensile and Elongation Test. Characteristics of the crosslinked film backing are summarized in Table 2.

*d. Preparation of a thermally-conductive adhesive tape*

The thermally-conductive film prepared by the method described above was first corona-treated on both major surfaces to improved anchorage of the adhesive layers.

A 20 μm thick layer of pressure-sensitive adhesive (a transfer tape) was then prepared by coating a solvent-based acrylic pressure-sensitive adhesive comprising a copolymer of isooctyl acrylate and acrylic acid in a weight ratio of 96/4 onto a siliconized paper liner and dried at 110 °C.

A thermally-conductive adhesive tape was then prepared by laminating the transfer tape thus prepared to each side of the corona-treated thermally-conductive backing.

The adhesive tape was then tested according to the methods set forth above. Electrical and thermal properties of the tape of Example 1 are summarized in Table 3.

*Example 2*

Example 2 was prepared in a manner similar Example 1 with the exception that the amount of catalyst for promoting the moisture curing of the silane-grafted polyethylene film was raised to 0.13 wt. % based on the total weight of the precursor. Tests were conducted on the extruded thermally-conductive film backing and the adhesive tape as in Example 1.

*Comparative Example 1*

Comparative Example 1 was prepared in a manner similar to Example 1 with the exception that the magnesium hydroxide filler was present in the amount of 55 wt. % based on the total weight of the precursor. Test results of the adhesive tape shown in Table 3 show an effective thermal conductivity of 0.390 W/m-K.

Table 1

| | Polymer | | | | Grafting agents | | Filler | Catalyst, |
|---|---|---|---|---|---|---|---|---|
| Ex. | Type, | Tradename | MFI | Wt. % | Silane, wt. % (pph*) | Peroxide, wt. % (pph*) | Mg(OH)$_2$, wt. % | wt. % |
| 1 | eth-co-octene | Engage 8400 | 30 | 33.08 | 0.66 (2.0) | 0.03 (0.085) | 66.16 | 0.07 |
| 2 | eth-co-octene | Engage 8400 | 30 | 33.06 | 0.66 (2.0) | 0.03 (0.085) | 66.12 | 0.13 |
| C1 | eth-co-octene | Engage 8400 | 30 | 44.00 | 1.96 (2.0) | 0.08 (0.085) | 53.76 | 0.20 |

wt. % = weight percent based on the total weight of the precursor
*pph = parts per 100 parts polymer)

Table 2

| Ex. | Mod. (N/mm$^2$) | E, max (%) | E, break (%) | Tens. max (N/mm$^2$) | Tens. break (N/mm$^2$) |
|---|---|---|---|---|---|
| 1 | 1.3 | 66 | 84 | 5.3 | 4.5 |
| 2 | 1.3 | 70 | 80 | 5.1 | 4.4 |
| C1 | 0.8 | 71 | 87 | 5.2 | 3.9 |

Table 3

| Ex. | Effective thermal conductivity | Thermal impedance | Breakdown voltage | Dielectric strength | Volume resistivity |
|---|---|---|---|---|---|
| | W/m- K | °C cm$^2$/W | kV | kV/mm | ohm-cm |
| 1 | 0.454 | 4.96 | 15.1 | --- | 2.9 x 10$^{15}$ |
| 2 | 0.435 | 4.95 | 13.0 | 63 | 3.1 x 10$^{15}$ |
| C1 | 0.390 | 6.22 | 15.7 | --- | 4.7 x 10$^{15}$ |

*Example 3*

A copolymer of ethylene and butyl acrylate (ethylene-co-butyl acrylate) was obtained in pellet form as LOTRYL 35BA40 (ATOFINA, Duesseldorf, Germany). The polymer has a melt flow index of 40 g/10 min as measured at 190°C according to ASTM D-1238.

Dicumylperoxide (0.175 parts per 100 parts polymer or 0.057 wt. % based on the total weight of the precursor) and vinyl-trimethoxy silane (4.7 parts per 100 parts polymer or 1.542 wt. % based on the total weight of the precursor) were mixed together, then added to the pellets and mixed. The mixture then was fed into a single-screw extruder having thermal zones increasing in temperature from 160 °C to 220 °C, where grafting of the silane onto the polymer backbone occurred, promoted by thermal decomposition of the peroxide.

The silane-grafted polymer (100 parts by weight) was then compounded with the magnesium hydroxide (200 parts by weight) in a twin-screw extruder at 170°C, in a manner similar to that of Examples 1-2. The grafted and filled polymer was then pelletized.

The pellets of precursor were then extruded to a white opaque polymeric film having a thickness of 200 μm without the addition of catalyst.

The extruded thermally-conductive film backing was then crosslinked by spraying the extruded film with a catalyst solution comprising 5 % tin (II) ethyl hexanoate by weight in heptane. The film was allowed to stand at 23 °C for 4 hours and was then washed with distilled water and dried at 40 °C for 1 hour. The chemical composition of the film backing is summarized in Table 4. Measurements made on the cross-linked film backing include thickness and E-modulus, as well as elastic torque, S'. Properties of the thermally-conductive film backing are summarized in Table 5.

The thermally-conductive film was then corona treated on both sides. A 20 μm thick layer of acrylate-based pressure-sensitive adhesive having essentially the same composition and thickness as that employed in Examples 1-2 was then laminated to each side of the film, forming a thermally-conductive pressure-sensitive adhesive tape having a total thickness of approximately 250 μm.

The adhesive tape was then evaluated for its thermal properties including thermal conductivity and thermal impedance, as well as for its electrical properties including breakdown voltage, dielectric strength, effective thermal conductivity, thermal impedance and volume resistivity.

The properties of the adhesive tape are shown in Table 6.

*Example 4*

Example 4 was prepared in the manner of Example 3 with two exceptions: 1) the amount of vinyl silane employed in the grafting reaction was reduced to 3.45 parts per 100 parts polymer (or 1.136 wt. % based on the total weight of the precursor) and 2) the thickness of the extruded film backing was increased to ca. 220 μm. A pressure-sensitive adhesive tape was prepared from the crosslinked film backing in the same manner as for Example 3. Properties of the crosslinked film backing and the adhesive tape made from it are summarized in Tables 5 and 6 below.

*Example 5*

Example 5 was prepared in the same manner as Examples 3-4, with the exception that the amount of vinyl silane employed in the grafting reaction was reduced further to 2.00 parts per 100 parts polymer (or 0.662 wt. % based on the total weight of the precursor). The film backing was extruded at a thickness of ca. 166 μm.

The resulting adhesive tape had a thickness of ca. 206 μm.

*Comparative Examples 2-3*

Comparative Examples 2 and 3 show the behavior of precursors and polymeric film backings having less than 60 wt. % particulate thermally-conductive filler based on the total weight of the precursor. Comparative Examples 2 and 3 are similar to Example 4 in that the relative amounts of polymer and grafting agents (silane and perxoide) remained unchanged. Comparative Example 2 only has ca. 40 wt. % thermally-conductive filler and Comparative Example 3 comprises no filler.

The grafted polymers were extruded and crosslinked according to the same methods as the examples of the invention, and made into adhesive tapes. The reduced level of filler and the absence of filler, respectively, is clearly reflected in the thermal properties of the adhesive tapes as summarized in Table 6.

*Comparative Example 4*

Comparative Example 4 employed the same polymer and filler, in the same relative amounts, as in Examples 3-5. No grafting reaction was performed, however. Thus the polymer could not be crosslinked by a moisture-curing reaction.

*Comparative Examples 5 and 6*

Two experiments were performed to show the effect of employing a polymer having a melt flow index of less than 20 in the precursor of the thermally-conductive material.

A copolymer of ethylene and methyl acrylate (ethylene-co-methyl acrylate) was obtained in pellet form as LOTRYL 28MA07 (ATOFINA, Duesseldorf, Germany). The polymer has a melt flow index of 7 g/10 min (as measured at 190 °C according to ASTM D-1238).

Comparative Example 5 was prepared by a method essentially the same as that of Example 5, with the exception that the much higher molecular weight LOTRYL 28MA07 was employed as the crosslinkable polymer. LOTRYL 28MA07 has a melt flow index of 7 g/10 min. Amounts of grafting agents and grafting conditions suitable for polymers having a melt flow index of 30 g/10 min were found to be unsuitable for a chemically-similar polymer having a melt flow index of 7 g/10 min. The resulting extruded film was stiff and unsuitable for used as a backing for a thermally-conductive adhesive tape.

Comparative Example 6 was prepared using a 50/50 wt/wt mixture of LOTRYL 17BA07 and magnesium hydroxide filler. The amounts of grafting agents were selected so that the amount of vinyl silane employed was substantially reduced to 1 part per 100 parts polymer (or 0.985 w.t % based on the total weight of the precursor) and the level of dicumyl peroxide employed as a free-radical initiator was raised substantially to 0.5 parts per 100 parts polymer (or 0.493 wt. % based on the total weight of the precursor.) Attempts to perform the grafting reaction resulted in a mass that crosslinked to such an extent under extrusion conditions that it was not possible to obtain an extruded film.

Table 4

| | Polymer | | | | Grafting agents | | Filler |
|---|---|---|---|---|---|---|---|
| Ex. | Type, | Tradename | MFI | Wt. % | Silane, wt. % (pph*) | Peroxide, wt. % (pph*) | $Mg(OH)_2$, wt. % |
| 3 | E-co-BA | LOTRYL 35BA40 | 40 | 32.800 | 1.542 (4.70) | 0.057 (0.175) | 65.601 |
| 4 | E-co-BA | LOTRYL 35BA40 | 40 | 32.935 | 1.136 (3.45) | 0.058 (0.175) | 65.871 |
| 5 | E-co-BA | LOTRYL 35BA40 | 40 | 33.093 | 0.662 (2.00) | 0.058 (0.175) | 66.187 |
| C2 | E-co-BA | LOTRYL 35BA40 | 40 | 58.954 | 2.034 (2.00) | 0.103 (0.175) | 38.909 |
| C3 | E-co-BA | LOTRYL 35BA40 | 40 | 96.502 | 3.329 (3.45) | 0.169 (0.175) | 0 |
| C4 | E-co-BA | LOTRYL 35BA40 | 40 | 33.333 | 0 | 0 | 66.667 |
| C5 | E-co-MA | LOTRYL 28MA07 | 7 | 33.093 | 0.662 (2.00) | 0.058 (0.175) | 66.187 |
| C6 | E-co-MA | LOTRYL 28MA07 | 7 | 49.261 | 0.985 (1.0) | 0.493 (0.5) | 49.261 |

wt. % = weight per cent based on the total weight of the precursor
*pph = parts per 100 parts polymer

Table 5

| Example | E-Modulus of crosslinked themally-conductuve film backing | Elastic torque, S', of uncrosslinked precursor | Elastic torque, S', of crosslinked thermally-conductive material |
|---|---|---|---|
| | $(N/mm^2)$ | (dNm) | (dNm) |
| 3 | $33 \pm 9$ | 0.66 | 5.73 |
| 4 | $31 \pm 2$ | 0.73 | 4.90 |
| 5 | $20 \pm 2$ | --- | --- |
| C2 | $12 \pm 1$ | --- | --- |
| C3 | $6 \pm 1$ | 0.06 | 0.35 |
| C4 | $50 \pm 3$ | --- | --- |
| C5 | $17 \pm 4$ | 1.63 | 5.86 |
| --- = not measured | | | |

Table 6

| Example | Therm. conductivity | Thermal impedance | Breakdown voltage | Dielectric Stength | Volume Resistivity |
|---|---|---|---|---|---|
| | W/m-°C | °C-cm$^2$/W | kV | kV/mm | (Ohm-cm) |
| 3 | 0.466 | 5.222 | 16.2 | 68.6 | $1.44 \times 10^{13}$ |
| 4 | 0.484 | 5.388 | 17.2 | 65.8 | $1.20 \times 10^{13}$ |
| 5 | 0.476 | 5.320 | 13.8 | 67,.3 | $1.61 \times 10^{13}$ |
| C2 | 0.422 | 5.095 | 14.2 | 71.1 | $1.11 \times 10^{13}$ |
| C3 | 0.250 | 10.731 | 17.0 | 69.0 | $6.44 \times 10^{12}$ |
| C4 | 0.558 | 4.846 | 15.8 | 71.3 | $1.20 \times 10^{13}$ |
| C5 | 0.495 | 5.97 | 14.2 | 56.3 | $6.60 \times 10^{12}$ |

**Claims**

1. Thermally-formable and cross-linkable precursor of a thermally-conductive material comprising

   a) one or more crosslinkable polymers where the melt flow index of the polymer or mixture of polymers (measured at 190°C according to ASTM D-1238 ), respectively, is 10-100 g/10 min and
   b) one or more thermally-conductive fillers in an amount of at least 60 wt. % of the total weight of the precursor.

2. Precursor according to claim 1 wherein the crosslinkable polymers are selected from a group consisting of polyolefins and polyurethanes.

3. Precursor according to any of claims 1 -2 wherein the crosslinkable polymer is a polyolefin having at least 30 % by weight ethylene units.

4. Precursor according to any of claims 1 - 3 wherein the polyolefin is selected from the group comprising copolymers of ethylene and (meth)acrylate esters.

5. Precursor according to any of claims 1 - 4 wherein at least one of the crosslinkable polymers comprises one or more moisture-curable groups.

6. Precursor according to claim 5 wherein the moisture-curable groups comprise silane groups.

7. Precursor according to claims 5 - 6 wherein the crosslinkable polymer is obtainable by reacting a polymer according to any one of the claims 1 - 6 with one or more vinyl silane compounds of the formula RR'SiY$_2$ (I), wherein R is a monovalently olefinically unsaturated radical, R' is a monovalent radical free of aliphatic unsaturation and Y is a hydolyzable organic radical, and a free-radical initiator.

8. Precursor according to claim 7 wherein the vinyl silane compound(s) (I) are employed in an amount of at least 2 parts per 100 parts crosslinkable polymer or polymers.

9. Precursor according to any of the claims 7 - 8 wherein the free-radical initiator is selected from the group consisting of an organic peroxide and an organic perester.

10. Precursor according to claim 9 wherein the free-radical initiator is employed in the amount of at least 0.1 parts per 100 parts crosslinkable polymer or polymers.

11. Precursor according to any of claims 5 - 10 comprising a catalyst for moisture-curing of the moisture-curable group in an amount of greater than 0.05 wt. % based on the total weight of the precursor.

12. Precursor according to any one of claims 1 - 11 wherein the thermally-conductive filler is selected from a group consisting of alumina, aluminum oxide, aluminum trihydroxide and magnesium hydroxide.

13. Method of manufacturing the precursor of any of the claims 1-12 comprising the steps of:

   a) providing one or more crosslinkable polymers where the melt flow index of the polymer or mixture of polymers (measured at 190 °C according to ASTM D-1238 ), respectively, is 10-100 g/10 min and
   b) compounding the polymer or polymers with one or more thermally-conductive fillers in an amount of 60 wt. % of the total weight of the precursor in a heated mixing device.

14. Method of manufacturing the precursor of any of the claims 7-12 comprising the steps of:

   a) providing one or more crosslinkable polymers where the melt flow index of the polymer or mixture of polymers (measured at 190 °C according to ASTM D-1238 ), respectively, is 10-100 g/10 min and where at least one of the polymers has an ethylene unit content of at least 30 % by weight,
   b) reacting the polymer with a vinyl silane of the formula (I), wherein R is a monovalently olefinically unsaturated radical, R' is a monovalent radical free of aliphatic unsaturation and Y is a hydolyzable organic radical, and a free-radical initiator in a heated mixing device to produce a moisture-curable polymer and
   c) compounding the moisture-curable polymer or polymers, respectively, with one or more thermally-conductive fillers in the amount of at least 60 wt. % in a heated mixing device.

15. Method of manufacturing a shaped thermally-conductive material comprising the steps of:

   a) providing the precursor of any of the claims 1 - 12,
   b) thermally forming the precursor to a desired shape and
   c) crosslinking the precursor.

16. Method of claim 15 where the precursor is thermally-formed into the shape of a film by extrusion.

17. Thermally-conductive material obtainable by the method of any of the claims 13 - 16.

18. Adhesive tape comprising at least a film backing bearing an adhesive layer on at least one of the major surfaces of the film backing, wherein the film backing is obtainable by extruding the precursor according to any of the claims 1-12 into the shape of a film and crosslinking the film.

19. Adhesive tape according to claim 18 having a dielectric strength of at least 55 kV/mm as measured according to DIN EN 60243-1.

20. Adhesive tape according to any of the claims 17 - 19 having an effective thermal conductivity of at least 0.4 W /m-K as measured according to ASTM D 5470-95.

21. Adhesive tape according to any of the claims 17 - 20 having a thickness of less than 300 $\mu$m.

22. Adhesive tape according to any of the claims 17-21 where the crosslinked thermally-conductive material of the film backing has an elastic torque, S', of between 5 dNm and 8 dNm, as measured according to ASTM D 6294-9.

23. Adhesive tape of any of the claims 17-22, wherein the adhesive is a pressure-sensitive adhesive.

24. Use of an adhesive tape according to any of the claims 17 - 23 for providing thermal conductivity between two substrates.

25. Assembly comprising the adhesive tape according to any of the claims 17 - 23 in a bonding relationship between two substrates.

## Figure 1

**European Patent Office**

## EUROPEAN SEARCH REPORT

Application Number

EP 02 02 8904

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 114 724 A (ICI PLC) 1 August 1984 (1984-08-01) | 1-17 | C09J7/02 C08L23/26 |
| Y | * page 1, line 33 - page 4, line 35 * * page 8, line 18 - page 11, line 6; claims; examples * --- | 18-25 | C08L75/04 C08K3/00 C08K3/22 H01L23/36 H01L23/373 |
| Y | WO 97 05206 A (SALTHOUSE PETER WILLIAM ;STEWART EDWARD JOHN (GB); PRESTON JOSEPH) 13 February 1997 (1997-02-13) * page 2, paragraph 2 - page 3, paragraph 2; claims 1,2 * --- | 18-25 | |
| X | EP 0 570 160 A (SUMITOMO CHEMICAL CO) 18 November 1993 (1993-11-18) | 1-4,9-17 | |
| Y | * page 2, line 1 - page 4, line 21; claims 10-12 * --- | 5-8, 18-25 | |
| X | WO 01 83210 A (TRIOPLANEX FRANCE S A ;GUSTAFSON BO (SE)) 8 November 2001 (2001-11-08) * page 12, line 4 - page 18, line 10 * * page 20, line 5-27 * * page 22, line 24 - page 25, line 21 * * page 26, line 19 - page 27, line 32; claims 14,33 * --- | 1-4,12, 13,15-25 | TECHNICAL FIELDS SEARCHED (Int.Cl.7) C09J C08L C08K H01L |
| X | FR 2 607 054 A (PLUSS STAUFFER AG) 27 May 1988 (1988-05-27) * page 8, line 10 - page 9, line 9 * * page 10, line 1 - page 12, line 4 * | 1-4,9-17 | |
| Y | * page 14, line 4 - page 15, line 23; claims; examples * --- | 5-8, 18-25 | |
| X | EP 0 454 508 A (ATOCHEM ELF SA) 30 October 1991 (1991-10-30) | 1-17 | |
| Y | * page 2, line 1-11 * * page 2, line 45 - page 5, line 12; claims * --- | 18-25 | |

-/--

The present search report has been drawn up for all claims

| Place of search | Date of completion of the search | Examiner |
|---|---|---|
| MUNICH | 7 February 2003 | Otegui Rebollo, J |

**European Patent Office**

# EUROPEAN SEARCH REPORT

Application Number

EP 02 02 8904

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 194 480 A (BLOCK JACOB ET AL) 16 March 1993 (1993-03-16) * column 1, line 4 - column 3, line 18; claims; examples * ----- | 1-25 | |

TECHNICAL FIELDS SEARCHED (Int.Cl.7)

The present search report has been drawn up for all claims

| Place of search | Date of completion of the search | Examiner |
|---|---|---|
| MUNICH | 7 February 2003 | Otegui Rebollo, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 02 8904

This annex lists the patent family members relating to the patent documents cited in the above-mentioned European search report.
The members are as contained in the European Patent Office EDP file on
The European Patent Office is in no way liable for these particulars which are merely given for the purpose of information.

07-02-2003

| Patent document cited in search report | | Publication date | Patent family member(s) | | Publication date |
|---|---|---|---|---|---|
| EP 0114724 | A | 01-08-1984 | AU | 2329484 A | 19-07-1984 |
| | | | EP | 0114724 A2 | 01-08-1984 |
| | | | NZ | 206811 A | 31-03-1987 |
| WO 9705206 | A | 13-02-1997 | AU | 6623396 A | 26-02-1997 |
| | | | CA | 2228313 A1 | 13-02-1997 |
| | | | EP | 0839169 A1 | 06-05-1998 |
| | | | WO | 9705206 A1 | 13-02-1997 |
| | | | JP | 11510200 T | 07-09-1999 |
| | | | TW | 476781 B | 21-02-2002 |
| | | | US | 6200677 B1 | 13-03-2001 |
| EP 0570160 | A | 18-11-1993 | JP | 6041370 A | 15-02-1994 |
| | | | CA | 2092488 A1 | 12-11-1993 |
| | | | EP | 0570160 A2 | 18-11-1993 |
| | | | KR | 270464 B1 | 01-12-2000 |
| | | | US | 5438101 A | 01-08-1995 |
| | | | US | 5523353 A | 04-06-1996 |
| WO 0183210 | A | 08-11-2001 | FR | 2808470 A1 | 09-11-2001 |
| | | | AU | 5848401 A | 12-11-2001 |
| | | | WO | 0183210 A1 | 08-11-2001 |
| FR 2607054 | A | 27-05-1988 | FR | 2607054 A1 | 27-05-1988 |
| EP 0454508 | A | 30-10-1991 | FR | 2659974 A1 | 27-09-1991 |
| | | | CA | 2039014 A1 | 27-09-1991 |
| | | | EP | 0454508 A1 | 30-10-1991 |
| | | | FI | 911438 A | 27-09-1991 |
| | | | IE | 910983 A1 | 09-10-1991 |
| | | | JP | 6087990 A | 29-03-1994 |
| | | | NO | 911109 A | 27-09-1991 |
| | | | PT | 97132 A | 29-11-1991 |
| | | | US | 5166250 A | 24-11-1992 |
| US 5194480 | A | 16-03-1993 | NONE | | |

EPO FORM P0459

For more details about this annex : see Official Journal of the European Patent Office, No. 12/82